Europäisches Patentamt

European Patent Office

Office européen des brevets

(11) Publication number: 0 334 397 A2

# EUROPEAN PATENT APPLICATION

(21) Application number: 89109817.0

(22) Date of filing: 16.05.85

(51) Int. Cl.4: H01L 23/50 , H01L 23/12 , H01L 23/14

(30) Priority: 18.05.84 GB 8412674

(43) Date of publication of application:
27.09.89 Bulletin 89/39

(60) Publication number of the earlier application in accordance with Art.76 EPC: 0 165 705

(84) Designated Contracting States:
AT BE CH DE FR GB IT LI LU NL SE

(71) Applicant: BRITISH TELECOMMUNICATIONS public limited company
81 Newgate Street
London EC1A 7AJ(GB)

(72) Inventor: Whitehead, Graham Keith
55 Westland Martlesham Heath
Ipswich Suffolk IP5 7SU(GB)
Inventor: Taylor, Kenneth
96 Woodfield Drive
East Barnet Herts(GB)

(74) Representative: Semos, Robert Ernest Vickers et al
BRITISH TELECOM Intellectual Property Unit
13th Floor 151 Gower Street
London WC1E 6BA(GB)

(54) Circuit board.

(57) A circuit board may be moulded from an aromatic thermoplastic material, the circuit board comprising one or more die attachment sites moulded therein preferably with the die attachment site recessed so that the surface of the die 9 is co-planar with conductive tracks on the board. The die attachment sites may be moulded with a relief pattern therein so that thermally induced strains of an attached die are reduced.

Also for the same reason a heat sink may be attached underneath the carrier below the carrier's die attachment site and thermally conductive material may connect them together. The heat sink may be used for mechanical anchorage.

## CIRCUIT BOARD

This invention relates to a circuit board and more particularly to a circuit board made from a plastics material and including die attachment sites adapted to act as chip carriers.

Known forms of chip carrier consist of a usually square base of ceramic material. A central area on the base is provided on to which an integrated circuit chip or die is mounted and secured, for example using a eutectic (gold/silicon) bond or an epoxy resin adhesive. Connections are then made between the appropriate points on the die to metal bonding pads provided on the carrier base. A preformed metallisation pattern on the carrier base connects the bonding pads to terminal contacts formed around the periphery of the base or to leads. A ceramic lid is then secured over the base so as to enclose and protect the die. The chip is thereafter mounted on a printed circuit board together with a series of other chip carriers and electronic components that go to form the complete circuit.

These packages, though available in large quantities, do require that the chip is bonded to the carrier before the combination is encapsulated in the protective cover. As a consequence the chip manufacturer is usually involved in the package production. This is often convenient for those chips that are considered to be "large production runs". However, increasingly it would be convenient if there was a source of pre-manufactured packages, of the required shape, into which the chips could be introduced for protection.

Because the process by which a ceramic package is made precludes the introduction of the device until the package is complete, they were until recently the most readily available packages for this application. However, the use of ceramic material for the chip carrier is expensive and problems can also arise when the ceramic base is later bonded to a conventional epoxy-glass printed circuit board, due to the differential expansion between the two materials. In extreme environmental conditions the ceramic chip carrier can break away from the printed circuit board.

It is also known to make chip carriers of plastics materials, and with these it is possible to match the thermal coefficient of expansion (TCE) of the carrier to that of the circuit board. However, even with matched TCEs there may still be problems with differential expansion - the chip within the carrier is a source of heat which will tend to heat the carrier more rapidly than the circuit board, and hence even with identical TCEs the carrier can expand more rapidly than the circuit board.

Certain plastics chip carriers also suffer from the disadvantage that their wire bonding pads and their terminal pads are metallised in the same operation, with the result that the thickness of gold (which is the preferred final coat) is the same on both pad types. This causes problems where the terminal pads are to be soldered to, as the thickness of gold on the terminal pads must be kept below about 0.2 micrometres to prevent excessive enbrittlement of the solder. This requirement that terminal pads have gold less than 0.2 micrometres thick conflicts with the need for 2 micrometres thickness gold for optimum bonding of wires to the bonding pads. The additional complexity and expense involved in providing the optimum thickness of gold to each pad type makes such an approach unattractive, and in consequence poor wire bonding is accepted.

One plastics material chip carrier is disclosed in JP57196548A (see e.g. patents abstracts of Japan Volume 7 Number 45 (E-160) (1190)).

This invention seeks to provide a circuit board which utilises improved chip carrier techniques to overcome the problems associated with previous kinds of chip carrier.

For the avoidance of doubt the chip carriers described hereinafter with reference to the drawings are the subject of applicants co pending European Patent Applications No 85303447 (publication No EP165705) and (A23054/2/EP).

According to the present invention we provide a circuit board comprising a body having at least one recess with a die attachment site therein, metallised conductive tracks on the surface of the body and contact pads on the conductive tracks for connection to the die, or dies, in which the body is formed by injection moulding from an aromatic thermoplastic polymer.

Embodiments of the present invention will now be described by way of example with reference to the accompanying drawings in which:

Figure 1a is a perspective view of a chip carrier prior to bonding its lid to its body;

Figure 1b is a cross sectional view of the carrier and lid of Figure 1a taken on the line xx;

Figure 1c is a cross-sectional view of a chip carrier having an alternative form of construction;

Figure 2a is a plan view of a 10 x 10 array of chip carriers prior to separation;

Figure 2b shows details of the conductors of the array of Figure 2a;

Figure 2c shows a multiple chip carrier according to the present invention;

Figure 3a shows a cross-sectional view of a chip carrier having an alternative form of construction;

Figure 3b is a plan view from beneath of the chip carrier of Figure 3a;

Figure 3c is an isometric view of a part of the chip carrier of Figure 3A.

Figure 4 is a cross-sectional view through a chip carrier having plated through holes to provide improved heat shedding capacity;

Figure 5 is a cross-sectional view through a chip carrier having an inserted combination die bond pad and thermal pillars;

Figure 6 is a perspective view of a chip carrier having staggered contacts; and

Figure 7 shows the chemical formula of a polymer for use in forming the chip carrier.

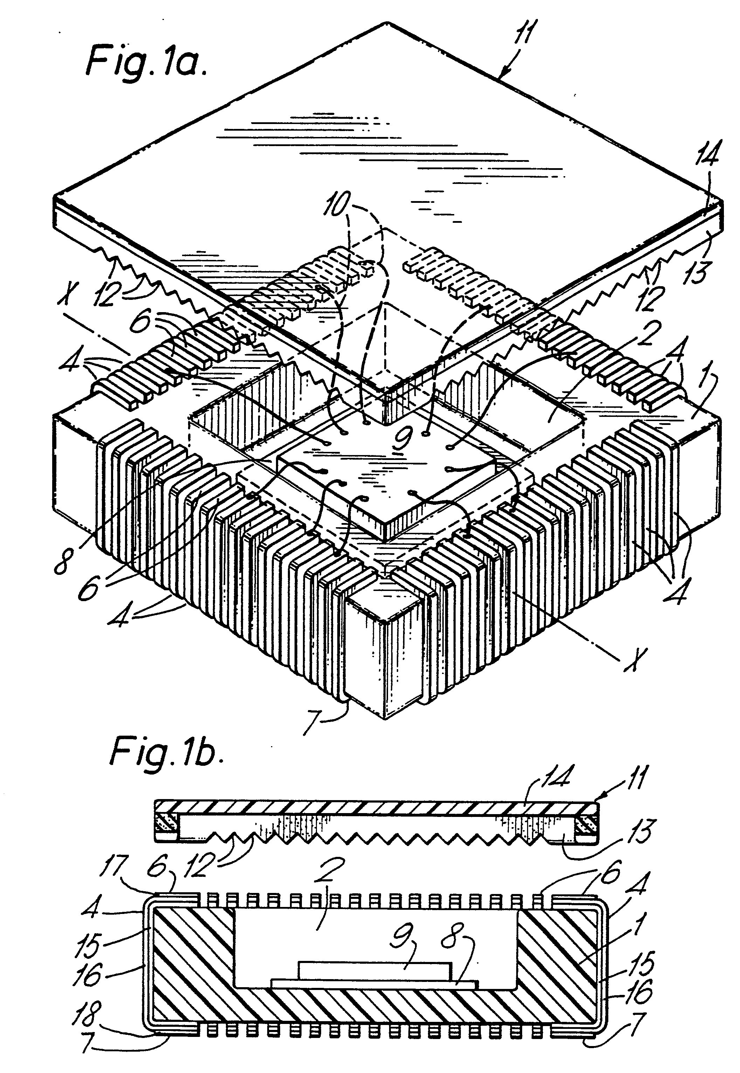

Referring now to Figure 1a, a chip carrier 1 is moulded with a central die mounting cavity 2. About the edge of the chip carrier a plurality of metallised contacts 4 are provided. Each of the contacts comprises a metallisation which extends from the carrier's upper surface, down the side wall, and onto the carrier's upper surface is coated with gold to form a pad suitable for wire bonding. The corresponding contact part 7 on the lower surface is coated with a metal such as tin or an alloy such as tin/lead suitable for forming a solderable contact pad.

In the die mounting cavity a die bonding pad 8 is formed by metallisation. A die 9 is shown bonded (for example, with an epoxy resin) to the die bonding pad. Electrical contact is made to the various parts of the die by bonding aluminium or gold wires 10 to the die 9 and to the wire bonding pads 6.

A chip carrier as described above can be fabricated by injection moulding techniques. Suitable plastics for use in moulding such a chip carrier include aromatic polymers such as polyether ether ketone (PEEK) and polyethersulphone (PES) sold under the name VICTREX by ICI; polysulphone sold under the name UDEL by Union Carbine; and polyetherimide sold under the name ULTEM by General Electric. The structure of these polymers is as follows:

Polyether ether ketone $[-C_6H_4-CO-C_6H_4-O-C_6H_4-O-]n$

Polyethersulphone $[-C_6H_4-SO_2-C_6H_4-O-]n$

UDEL Polysulphone $[-C_6H_4-SO_2-C_6H_4-O-C_6H_4-C_3H_6-C_6H_4-O]n$

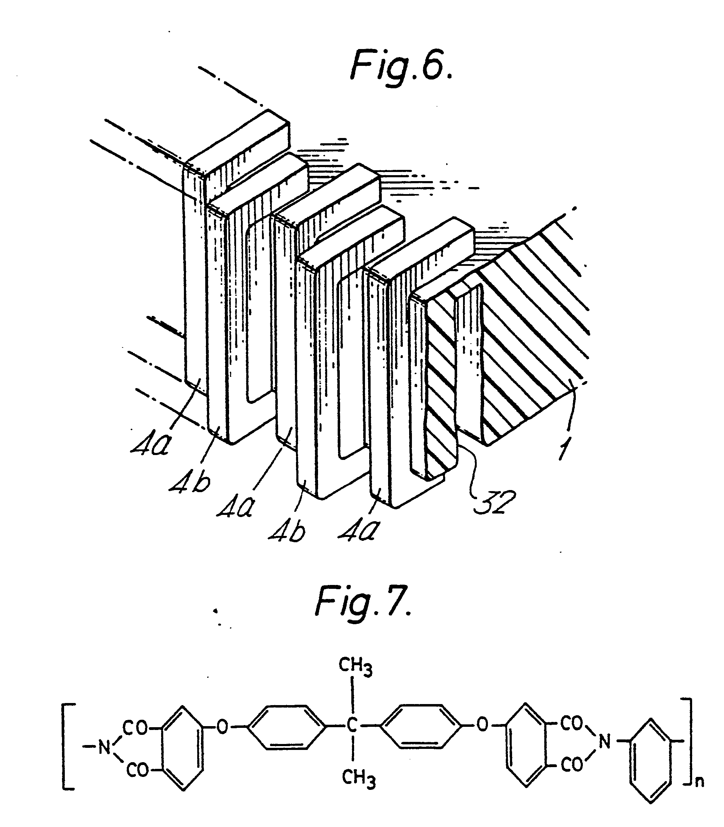

Polyetherimide - see Figure 7.

The principal factors which have to be taken into consideration when choosing a polymer for use in moulding chip carriers according to the present invention are:

1) ability to withstand subsequent processing conditions, notably temperatures encountered during soldering - generally at least 215°C in vapour phase tanks. This requires a glass transition temperature (Tg) of about 230°C or more - although lower soldering temperature and/or shorter transit times may allow the use of polymers having lower glass transition temperatures.

2) The polymer should be free of undesirable outgassing so that circuit reliability is not jeopardised.

3) The polymer should be mouldable, preferably by injection moulding.

4) The polymer should preferably be weldable (ultrasonically or otherwise) so that it is not necessary to use glues or adhesives (which can give rise to contamination problems in service).

5) The polymer should accept metallisation, and preferably should be compatible with fully additive processing.

6) The polymer should preferably accept pigments as some circuits are light activated and require opaque carriers.

7) The polymer should preferably have a coefficient of expansion comparable to that of the circuit board material with which the carriers are to be used -typically this would be about 17 to 23 x $10^{-6}$ °C$^{-1}$.

Referring again to Figure 1a, in order to protect the die and the wire bonding from direct physical contact and contamination, a lid 11 is provided. The lid 11 is moulded from a material compatible with that of the body of the chip carrier to enable them to be joined without the use of glues, eg by ultrasonic welding. Because the contacts 4 are deposited on the surface of the chip carrier, they provide a stepped surface, and it is to this that the lid has to be sealed. For this reason the lid's lower surface is provided with indentations 12 in positions corresponding to the positions of contacts 4. In order to provide effective sealing, the indentations are made somewhat smaller than the contacts 4 which they are to receive, and in the example shown they are triangular, with the apex uppermost. During the welding of the lid to the base, pressure is applied to urge the lid towards the base, causing the lid to deform around the contacts to provide an effective seal to the contacts and the base. If desired an encapsulant (junction coating) can be applied to the wire bonded chip to provide additional mechanical and environmental protection during handling. The combined lid and body cavity serves to retain any such encapsulant. However, since encapsulant often flows too freely prior to the bonding of the lid to the body the lid may be made in two parts: the first part 13 comprises a sidewall, and the second part 14 a cap. The sidewall 13 is welded to the carrier body, encapsulant can then be applied to the wire bonded chip, and the cap 14 is then welded onto the sidewall 13.

It is possible to achieve a high degree of sealing with the chip carriers and they may be particularly suitable for use in high humidity environments.

In Figure 1b the construction of the chip carrier 1 and contacts 4 can more clearly be seen. The contacts 4 comprise multiple metallic coatings; a first coating 15 of copper, a .25mm nickel coating 16 over the copper, a gold coating 17 over the nickel on the upper end of the contact to form the wire bonding pad 6, and a tin or tin/lead alloy coating 18 over the nickel of the lower end of the contact to form a solderable terminal pad 7.

In an alternative form of construction, the die bonding pad 8 can advantageously have a construction whereby differential thermal expansion between the chip carrier and the die 9 itself is better accommodated. (It will be appreciated that, whereas the carrier material has a typical TCE of $23 \times 10^{-6}$ $^{\circ}C^{-1}$, that of silicon is about $2 \times 10^{-6}$ $^{\circ}C^{-1}$.) This construction (see Figure 1c) could be such that the die bonding pad 8 comprises a relief pattern 30 such as series of ribs, concentric rings, or a plurality of "pillars", or be "maze" shaped (the latter two constructions being even more advantageous than the first because they admit differential expansion in all directions in the relevant plane).

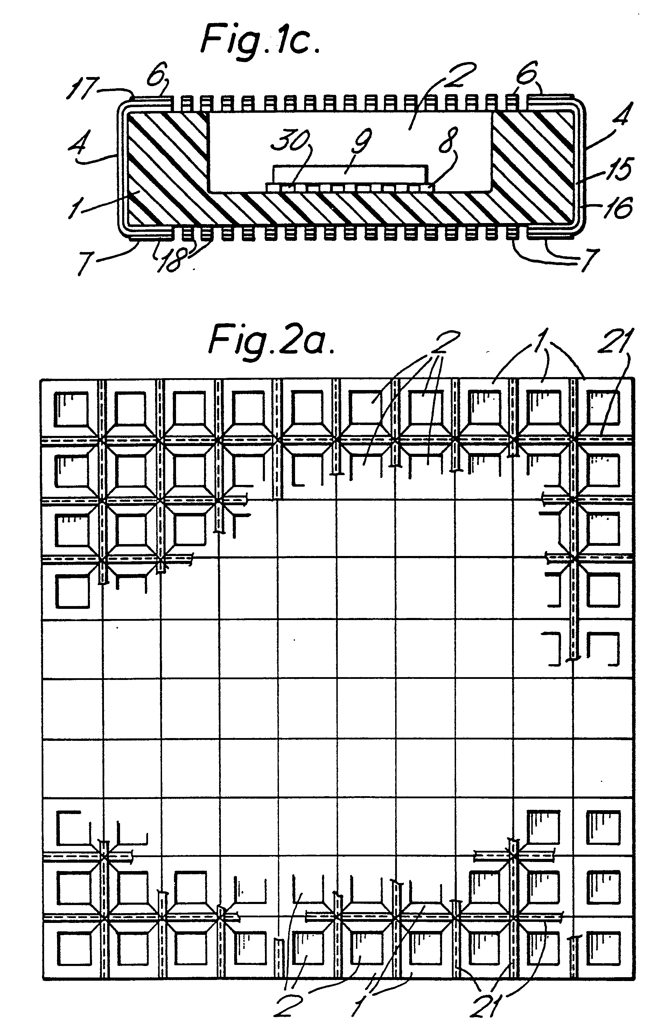

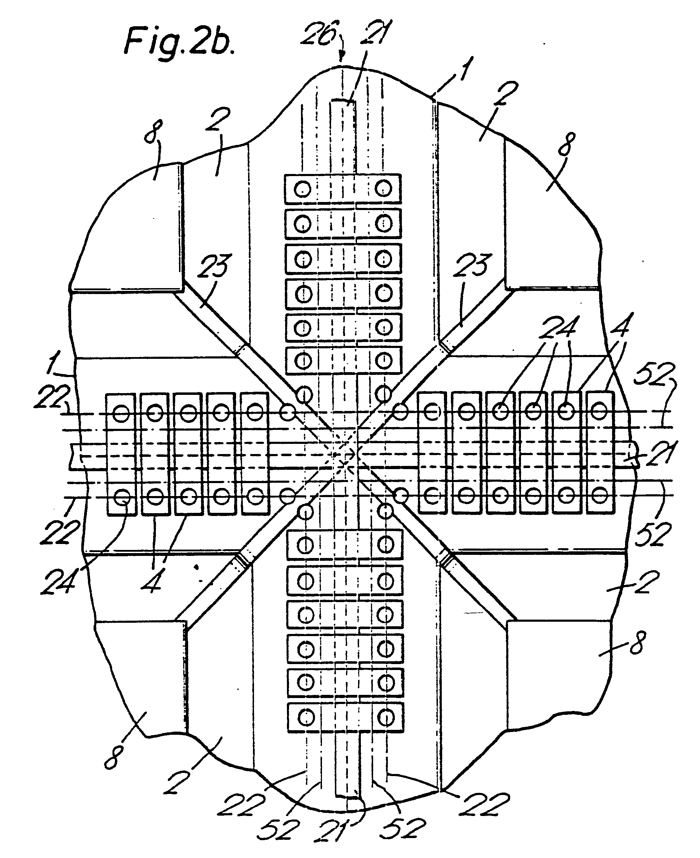

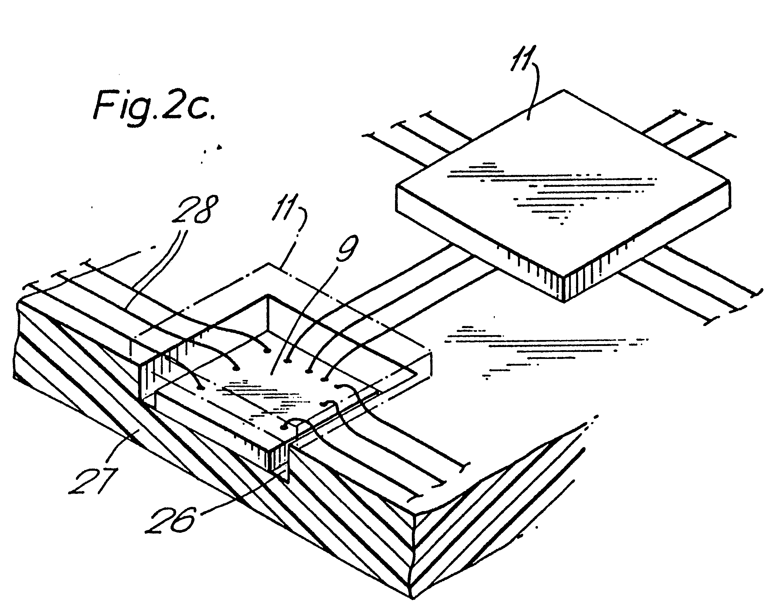

The chip carriers made by injection moulding in thermoplastic may conveniently be moulded in a matrix of for example 10x10. Such a matrix is shown in Figure 2a, and details of the arrangement of conductors etc between adjacent carriers is shown in Figure 2b. The matrix is moulded as a generally flat sheet containing the die cavities and the necessary holes for producing conductors 4. Note that chip carriers may be moulded without cavities, deeper lids being provided to supply the die mounting cavity. Preferably, however, the carrier body will have a moulded-in die mounting cavity, as this offers a number of advantages, including some protection against accidental damage during processing.

The described embodiments of the invention contemplate two alternative methods of producing the conductors 4 and die bonding pads 8. In the first "subtractive" method, a copper coating is formed by lamination or electroless deposition and etched using conventional resist techniques: desired coatings of nickel, gold, tin, etc can then be selectively plated. In the second "additive" method, all metallisation is initially carried out by electroless deposition and etching is unnecessary. The pattern, once defined, can be built up either electrolessly or by electroplating. Both methods have the advantage, as compared with processes where the final finish is used as a mask for etching the copper beneath, of avoiding the deposition of gold in areas where it is undesirable (for the reasons discussed earlier). This approach is made practicable by injection moulding whereby holes can be formed, easily at the moulding stage, avoiding a prohibitive amount of drilling being required to produce the necessary through-hole connections.

In the "additive" method, the conductors 4 and die bonding pads 8 are produced after the matrix is moulded, and, for this reason, it is not necessary to provide any metallic inserts during moulding. Processing may be facilitated by producing plating bars 21 in rows or as a grid between the individual chip carriers. In this way it is possible, if desired, to connect together all the chip carriers to form a single electrode.

The first stage in defining the conductor pattern involves rendering the surface of the plastic sufficiently sensitive to accept an electroless copper deposition. This may be done in any convenient way, although the preferred method is to use the resistless imaging process devised by PCK Technology of Melville New York and known as Photoforming. In this process the moulding is chemically etched to render this surface hydrophilic to enable deposition of a catalyst and electroless copper. After etching, the surface is activated with a solution containing an ultra violet (UV) photo initiator and copper salts. On exposure to UV light the copper ions present in the solution are reduced to metallic copper. It is therefore possible to produce the desired metallisation pattern in copper simply by exposing their requisite areas to UV light. Following this initial copper deposition, electroless copper deposition can be used to produce a thicker copper layer which can be used as an electrode in subsequent electroplating steps. It should be noted that for use in such processes the polymers discussed require treatment, such as doping with titanium dioxide to render them opaque to ultra-violet light.

Of course, other techniques, involving plating masks or resists can be used, but these will generally require many more process steps and are likely to increase production costs.

If plating bars (ie broad tracks) such as those shown at 21 in Figure 2b are used, it may be possible to dispense with the electroless copper plating step, and simply electroplate on the pattern defined in the photoforming step.

Following deposition of copper either electrolessly or electrolytically, a nickel coating is electro plated over the copper.

As can be seen in Figures 2a and 2b, all those parts of the chip carrier which are to be metallised, ie the contacts and the die bonding pads 8, can all be interconnected (the die bonding pads may be formed by insertion of a metallic stud or in some other way which does not require the pads to be plated, in which case they need not form part of the electrode). The tracks 21 serve to interconnect these regions on all the carriers and are removed when the matrix is separated to form individual carriers. This is most easily done by arranging the tracks 21 in the form of a lattice with one chip carrier per cell. As can be seen, there are no contacts 4 at the corners of the chip carriers (as this could result in different path lengths between the die and the different terminal pads 7), and these spaces allow tracks 23 to be run from the die bonding pads to the tracks 21 of the lattice. Alternatively tracks could be run directly from a contact 4 at the centre of one side of the carrier to the die bonding pad. These could be cut at a later stage or (if external connection to the semiconductor substrate is required) allowed to remain.

At the site of each contact 4 a hole or slot 24 is provided through the board. At each end of these holes or slots a metallised pad, (which on the upper surface of the chip carrier will form wire bonding pads 6 or on the lower side of the chip carrier will form the terminal pads 7) is provided. The photoforming step provides sufficient metallic copper on the walls of the holes 24 for subsequent metallisation to give fully plated through holes.

Following the nickel plating step the wire bonding pads are plated with 2 micrometres of gold. By using taped resists (ie resists or masks in the form of adhesive tapes) it is possible to quickly and easily mask both ends of the holes 4 and those surfaces of the carrier (including the underside) which are not to be plated with gold. It is thus possible to selectively plate with gold, so that none is applied to the terminal pads thereby avoiding subsequent embrittlement of the solder used to attach the chip carrier to a circuit board. As previously mentioned, the terminal pads may be precoated with a tin or lead alloy.

After completing the metallisation steps, the matrix of chip carriers can be divided into individual carriers either before or after dies are bonded and wired to the carriers, although usually the chip carriers will be separated before dies are bonded to them.

The matrix of chip carriers can have lines of weakness moulded into it, along the edges of the plating bars for example, so that it is possible (depending upon the material used) to snap off lines of carriers or individual carriers. If the precursors of the contacts 4 are slots or a combination of slots and holes, it may be possible to use them so the line of weakness along which the chip carriers may be separated by 'snapping' apart. Alternatively, the matrix may be divided up using a saw, for example a circular saw. In either case the conductive tracks which have been used during electroplating are removed during separation of adjacent carriers. Where each of the boundaries of each chip carrier is defined by a separate row of holes, as in Figure 2b, so that between any two adjacent carriers there are two rows of holes, the material removed during separation (for a leaded carrier) comprises that between the two rows of holes - viz by severing along lines 22 leaving each separated chip carrier with edges comprising flat portions between concave conductors 4. Where a single row of holes is used to produce the conductors 4 of two adjacent carriers separation must be carried out carefully to ensure that no conductors 4 are lost from any carrier during separation. Alternatively, for a leadless carrier, separation is along lines 52 leaving the holes 24 into which leads can be inserted.

If a totally electroless metallisation process is used, on the other hand, the plating bars become unnecessary, and in that case the carriers could be moulded as individual items joined only by fine webs at (for example) the corners.

A further advantage of making chip carriers by injection moulding is that the material used can have a coefficient of thermal expansion similar to that of most of the metal cored printed circuit boards (PCB) and substrates. As a result whole PCBs could be moulded having recesses at the chip sites like a multiple-chip carrier - and metallized as previously described. The chip would then be bonded into the cavities and protected with junction coatings. Then lids of the same nature as those proposed for the single-chip carrier could be welded into place to afford mechanical protection. The added benefit of this solution is that the tracking on the PCB could be taken directly into the chip housing and thus the problems of the package/board interface are removed. Figure 2c is a perspective view of part of such a construction in which a chip 9 is accommodated in a rectangular recess 26 in an injection moulded substrate 27, a lid 11 is shown covering another recess. Another advantage of this arrangement is that the absence of a separate carrier between the chip and a PCB, coupled with the location of the chip in a recess means that the upper, connecting, surface of the chip can be arranged to be co-planar with conductive tracks 28 on the substrate, providing superior transmission - line properties for highspeed/high frequency operation.

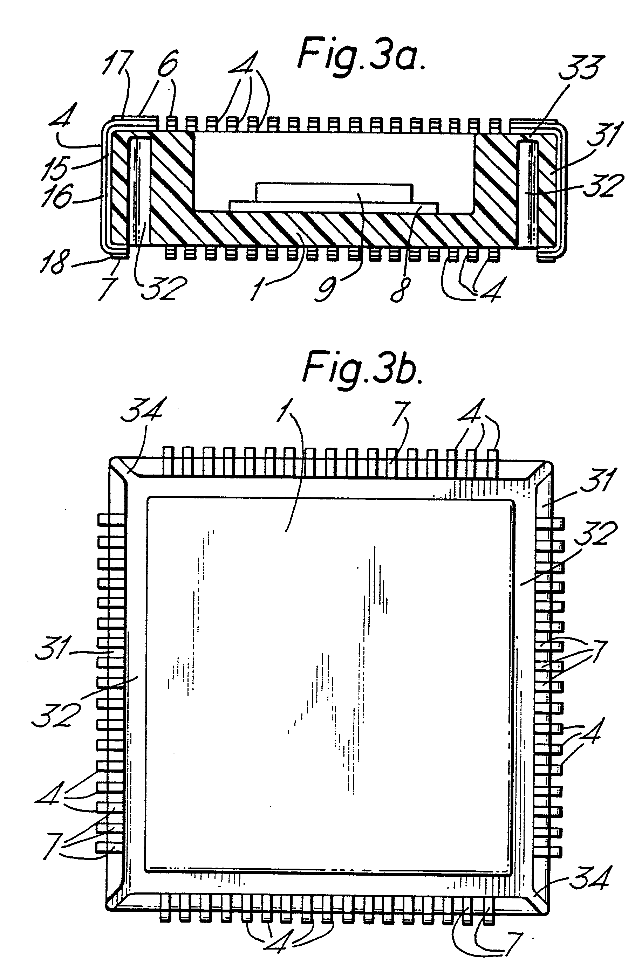

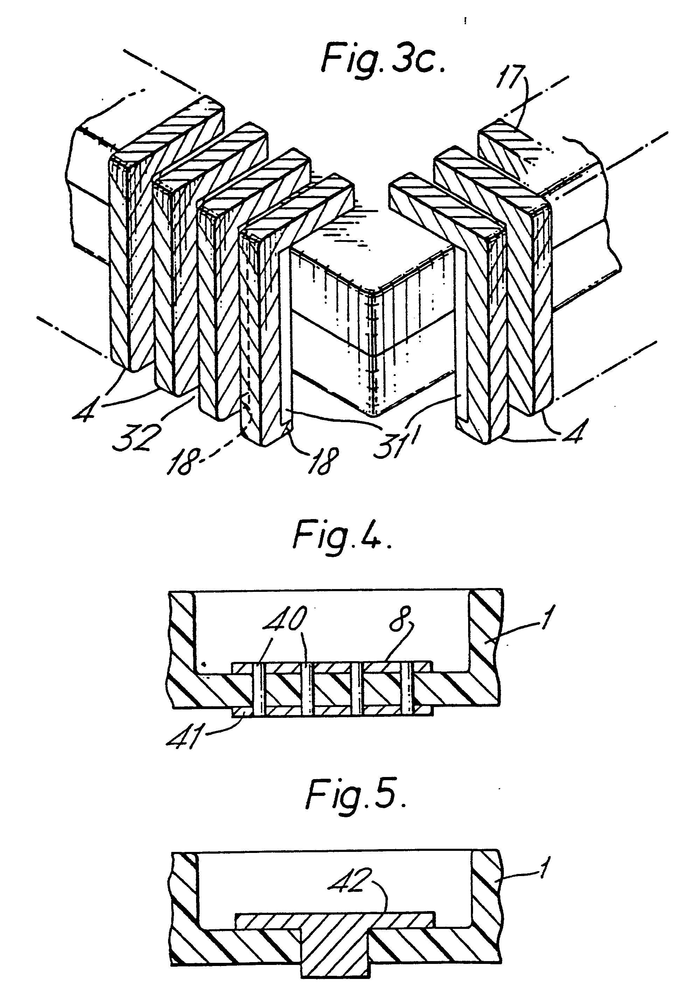

The problems of thermal strain in chip carriers produced by injection moulding or otherwise can be combatted by a variety of techniques; in addition to the provision of a relief profile in the die bonding pad, which is particularly advantageously produced by injection moulding techniques. Referring now to Figure 3; Figure 3a shows a chip carrier in which the side walls 31, which are metallised to form the contacts 4, are each separated from the main chip carrier body by a slot 32, which extends to virtually the full height of the side wall;

this side wall being connected to the main body by only a thin elastically deformable portion 33. The provision of these deformable portions enables the chip carrier to repeatedly accommodate relatively large strains resulting from differential thermal expansion without imposing large stresses on the solder joints between the terminal pads and the circuit board.

In Figure 3b it can be seen that at each corner of the chip carrier there is a gap 34 between the adjacent side walls. This gap allows the carrier to accommodate strain along its length and across its width. Where the amount of strain is expected to vary along the side wall, which may occur when the chip carrier is very large, it may be desirable to provide gaps in the side walls. There may be occasions when it is desirable to divide the side walls further, even to the point of having one side wall segment for each of the contacts 4. This is shown in Figure 3c, where the metallised parts 4 of the contacts are shown hatched; the underlying plastics part 31', which is integrally moulded with the rest of the carrier body, remains unshaded. It should be understood that the metallisation is formed over the divided sidewall, and that Figure 3c does not show separately added legs.

Alternatively for use with highly heat dissipative chips a thermal path maybe incorporated in the die bond pad, and various arrangements are shown in Figures 4 and 5.

The chip carrier shown in Figure 4 has several plated through holes 40 in the die bonding pad 8. These holes are produced at the same time and in the same way as the interconnection holes used to form the contacts 4. Alternatively, the holes can be left unplated and slugs of a thermally conductive material (eg copper) inserted. In either case, a thermal pad 41 on the underside of the chip carrier, corresponding to the die bond pad 8, would enhance heat transfer. For efficient heat transfer the thermal pad may be soldered to a corresponding contact on the circuit board to which the chip carrier is to be attached. Indeed, this form of attachment could be used as a means of mechanical anchorage even in the absence of thermally conductive material extending through the carrier. This solder connection can be replaced with a high heat conductivity grease to bridge any gap between the thermal pad and the circuit board. Alternatively the thermal pad may not be connected to the circuit board but left to radiate heat, as for instance, when included in an injection moulded multiple chip carrier.

Greater thermal transport may be provided by means of a legged platform or stud 42 (Figure 5) which can either be incorporated into the matrix during injection moulding, or inserted into a suitable hole formed during moulding. Alternatively, this stud may consist of two parts, an upper and a lower, which can be inserted or moulded in separately.

Where the thermal pad is to be soldered to the substrate it is preferable that the surface which is to be soldered comprises a number of discrete areas so that the formation of voids is minimised.

In addition to the improvement in heat transfer provided by soldering the thermal pad to the circuit board, there is a further advantage in that the gauge length over which the thermal stress acts is considerably reduced. Without the central attachment provided by the thermal pad the gauge length would be the distance between the side walls. With a thermal pad this is reduced to just twice the distance between the thermal pad and the side wall, ie the gauge length is reduced by the width of the thermal pad.

The problems of soldering the thermal pad 41 or an anchorage pad to a circuit board increase as the size of the chip (and carrier) increases. Reflow soldering is carried out by pre-coating the pad and contact pads with a solder paste comprising powdered solder, powdered flux and an organic binder. The application of heat (as uniformly as possible) by any of a number of known techniques, eg vapour phase soldering, causes flow of the solder and flux and a solder joint is formed.

The proposed construction further allows the use of a small circuit board track width and separation which may enable greater circuit densities to be realised. This can be achieved by offsetting adjacent terminal contacts on the carrier, for example by providing an inner and an outer row of terminal contacts as shown in Figures 6. It can be seen that the edge of the chip carrier is castellated, with an inner and an outer row of contacts 4a, 4b; the size and offset being such that the inner terminal contacts can be inspected by looking through the gaps between adjacent outer terminal contacts. In this way, it is possible for all the contacts between a chip carrier and a circuit board to be visually inspected. The provision of an inner and an outer row of terminal contacts allows the pitch of the contacts to be reduced, and hence allows denser packing, while maintaining adjacent solder pad separation.

The chip carriers may also be made compatible with circuit boards using plated through hole (pth) technology by providing them with leads. Such chip carriers are made as has been described above (although there is no need to provide terminal contacts on the carrier's lower surface), with each chip carrier having its own array of holes 24 which are to be used to provide contacts 4. The leads are inserted into the holes 24, either singly or in a ganged operation into several holes simultaneously using for example an automatic leading machine. The leads should be suitably sized to provide an efficient seal to the holes through which they pass.

After insertion the connecting pieces between ganged leads can be removed, and the leads left straight for through board insertion of 'joggled' to form a surface mounting footprint.

## Claims

1. A circuit board comprising a body characterised in that the body includes at least one recess with a die attachment site therein, metallised conductive tracks on the surface of the body and contact pads on the conductive tracks for connection to the die, or dies, in which the body is formed by injection moulding from an aromatic thermoplastic polymer.

2. A circuit board as claimed in Claim 1 further characterised in that the aromatic thermoplastic polymer is polyether ether ketone or polyethersulphone or polysulphone or polyetherimide.

3. A circuit board as claimed in Claim 1 or 2 further characterised in that the die attachment sites comprise a relief pattern.

4. A circuit board as claimed in any one of Claims 1 to 2 having dies mounted on the die attachment sites further characterised in that the connecting surface of the dies are co-planar with the contact pads.

5. A circuit board as claimed in any one of Claims 1 to 4 further characterised by including metallised heat sink pads on the underside beneath the die attachment sites in which the die attachment sites comprise regions having a higher thermal conductivity than the body, and including thermally conductive means extending through the body between the die attachment sites and the respective heat sink pads.

Fig.1a.

Fig.1b.

*Fig.1c.*

*Fig.2a.*

Fig.2b.

Fig.2c.

## Fig.3a.

## Fig.3b.

*Fig.3c.*

17

4

32

18

18

31

4

*Fig.4.*

10

8

1

41

*Fig.5.*

42

1

# Fig.6.

# Fig.7.